# EUROPEAN PATENT APPLICATION

(11) **EP 4 576 087 A1**
(43) Date of publication of application: **25.06.2025**
(21) Application number: 24214573.8
(22) Date of filing: 21.11.2024
(51) Int. Cl.: G11C 5/06, H01L 21/768, H01L 23/528

(54) **BACKSIDE LOGIC INTERCONNECTS**

(30) Priority: 21.12.2023 US 202318392579
(71) Applicant: Intel Corporation, Santa Clara, CA 95054 (US)
(72) Inventor: GUHA NEOGI, Tuhin, Sherwood, 97140 (US); JUN, Hwichan, Portland, 97229 (US)
(74) Representative: 2SPL Patentanwälte PartG mbB

(57) **Abstract**

Techniques are provided herein to form an integrated circuit having a backside interconnect structure coupled between different transistor source or drain regions. The backside interconnect structure may be used to replace frontside local interconnect structures, thus freeing up more space in the frontside interconnect region. A first semiconductor device includes a first semiconductor region extending between a first source or drain region and a second source or drain region, and a second semiconductor device includes a second semiconductor region extending between a third source or drain region and a fourth source or drain region. Each of the source or drain regions have corresponding backside contacts coupled to a bottom surface of the source or drain region. A backside conductive layer may extend beneath the semiconductor devices and be coupled to any of the backside contacts to provide connection between the corresponding source or drain regions.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Routing multiple logic signals between transistor elements in the interconnect region leads to inefficient use of the space and crowded metal lines that can increase parasitic effects. Accordingly, there remain a number of non-trivial challenges with respect to forming such high-density semiconductor devices.

### BRIEF DESCRIPTION OF THE DRAWINGS

Figure 1A is a top-down view of an integrated circuit structure that includes a backside interconnect to route logic signals between different source or drain regions, in accordance with an embodiment of the present disclosure.
Figures 1B and 1C are different cross-sectional views of the integrated circuit of Figure 1A that show the backside interconnect coupled to adjacent source or drain regions of the same transistor (1B), and coupled between adjacent source or drain regions of different transistors (1C), in accordance with an embodiment of the present disclosure.
Figures 2A and 2B are cross-sectional views that illustrate one stage in an example process for forming an integrated circuit configured with a backside interconnect such as shown in Figures 1A-C, in accordance with an embodiment of the present disclosure.
Figures 3A and 3B are cross-sectional views that illustrate another stage in the example process for forming an integrated circuit configured with a backside interconnect such as shown in Figures 1A-C, in accordance with an embodiment of the present disclosure.
Figures 4A and 4B are cross-sectional views that illustrate another stage in the example process for forming an integrated circuit configured with a backside interconnect such as shown in Figures 1A-C, in accordance with an embodiment of the present disclosure.
Figures 5A and 5B are cross-sectional views that illustrate another stage in the example process for forming an integrated circuit configured with a backside interconnect such as shown in Figures 1A-C, in accordance with an embodiment of the present disclosure.
Figures 6A and 6B are cross-sectional views that illustrate another stage in the example process for forming an integrated circuit configured with a backside interconnect such as shown in Figures 1A-C, in accordance with an embodiment of the present disclosure.
Figures 7A and 7B are cross-sectional views that illustrate another stage in the example process for forming an integrated circuit configured with a backside interconnect such as shown in Figures 1A-C, in accordance with an embodiment of the present disclosure.
Figures 8A and 8B are cross-sectional views that illustrate another stage in the example process for forming an integrated circuit configured with a backside interconnect such as shown in Figures 1A-C, in accordance with an embodiment of the present disclosure.
Figures 9A and 9B are cross-sectional views that illustrate another stage in the example process for forming an integrated circuit configured with a backside interconnect such as shown in Figures 1A-C, in accordance with an embodiment of the present disclosure.
Figures 10A and 10B are cross-sectional views that illustrate another stage in the example process for forming an integrated circuit configured with a backside interconnect such as shown in Figures 1A-C, in accordance with an embodiment of the present disclosure.
Figures 11A and 11B are cross-sectional views that illustrate another stage in the example process for forming an integrated circuit configured with a backside interconnect such as shown in Figures 1A-C, in accordance with an embodiment of the present disclosure.
Figures 12A and 12B are cross-sectional views that illustrate another stage in the example process for forming an integrated circuit configured with a backside interconnect such as shown in Figures 1A-C, in accordance with an embodiment of the present disclosure.
Figures 13A and 13B are cross-sectional views that illustrate another stage in the example process for forming an integrated circuit configured with a backside interconnect such as shown in Figures 1A-C, in accordance with an embodiment of the present disclosure.
Figures 14A and 14B are cross-sectional views that illustrate another stage in the example process for forming an integrated circuit configured with a backside interconnect such as shown in Figures 1A-C, in accordance with an embodiment of the present disclosure.
Figure 15 is a cross-sectional view of the integrated circuit with the backside interconnect and a backside power rail, in accordance with an embodiment of the present disclosure.
Figure 16 illustrates a cross-sectional view of a chip package containing one or more semiconductor dies, in accordance with some embodiments of the present disclosure.
Figure 17 is a flowchart of a fabrication process for a semiconductor device having a backside interconnect such as shown in Figures 1A-C, in accordance with an embodiment of the present disclosure.
Figure 18 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having a backside interconnect structure coupled between different transistor source or drain regions. The backside interconnect structure may be used to replace frontside local interconnect structures, thus freeing up more space in the frontside interconnect region (e.g., for metal 0 lines). The techniques can be used in any number of integrated circuit applications and are particularly useful with respect to logic and memory cells, such as those cells that use finFETs or gate-all-around transistors (e.g., ribbonFETs and nanowire FETs) or forksheet transistors (e.g., nanosheet FETs). In one such example, a first semiconductor device includes a first semiconductor region extending between a first source or drain region and a second source or drain region, and a second semiconductor device includes a second semiconductor region extending between a third source or drain region and a fourth source or drain region. Each of the source or drain regions have corresponding backside contacts coupled to a bottom surface of the source or drain region. A backside conductive layer may extend beneath the semiconductor devices and be coupled to any of the backside contacts to provide connection between the corresponding source or drain regions. Numerous variations and embodiments will be apparent in light of this disclosure.

### General Overview

As previously noted above, there remain a number of non-trivial challenges with respect to integrated circuit fabrication. In more detail, some circuit designs require complex connections to be made between various transistor elements of a given device layer. Due to inherent constraints in transistor layout, providing these connections often requires the use of local interconnect layers within the interconnect region. The interconnect region includes one or more interconnect levels formed above the devices of the device layer, during backend processing (sometimes called back end of line or BEOL processing). However, the presence of the local interconnect layers decreases the amount of space available for certain signal tracks within the lower interconnect levels, such as metal 0 lines.

Thus, and in accordance with an embodiment of the present disclosure, techniques are provided herein to form backside interconnect structures to provide connection between any number of transistor source or drain regions. In some examples, the backside interconnect structures are used instead of the frontside local interconnect layers, which can free up more space for metal 0 signal tracks in the interconnect region. According to some embodiments, a given backside interconnect structure may extend linearly between adjacent source or drain regions, or may have a non-linear shape to extend between any source or drain regions of the circuit. For example, the backside interconnect structure may have an 'L' shape to connect source or drain regions that are not aligned along each of an X-direction and a Y-direction. According to some embodiments, backside contacts beneath the source or drain regions provide a conductive bridge between the backside interconnect structure and the corresponding source or drain regions. In some examples, the backside interconnect structure extends beneath any number of source or drain regions without providing any electrical connection with them (e.g., flying under the source or drain regions). The backside interconnect structure may include any suitable conductive material, such as tungsten, titanium, tantalum, ruthenium, molybdenum, or cobalt, or a nitride of any of these.

According to an embodiment, an integrated circuit includes a first semiconductor device having a first semiconductor region extending in a first direction from a first source or drain region, a second semiconductor device having a second semiconductor region extending in the first direction from a second source or drain region, a first conductive contact on an underside of the first source or drain region, a second conductive contact on an underside of the second source or drain region, and a backside conductive layer coupled between the first conductive contact and the second conductive contact.

According to another embodiment, an integrated circuit includes a first semiconductor device having a first semiconductor region extending in a first direction from a first source or drain region, a second semiconductor device having a second semiconductor region extending in the first direction from a second source or drain region, a first dielectric layer beneath the first source or drain region and the second source or drain region, a first conductive contact extending through the first dielectric layer and contacting a lower surface of the first source or drain region, a second conductive contact extending through the first dielectric layer and contacting a lower surface of the second source or drain region, a second dielectric layer beneath the first dielectric layer, and a backside conductive layer extending through the second dielectric layer and contacting both the first conductive contact and the second conductive contact.

According to another embodiment, an electronic device includes a chip package having one or more dies. At least one of the one or more dies includes a first source or drain region as part of a first semiconductor device, a second source or drain region as part of a second semiconductor device, a first conductive contact on an underside of the first source or drain region, a second conductive contact on an underside of the second source or drain region, and a backside conductive layer coupled between the first conductive contact and the second conductive contact.

According to another embodiment, a method of forming an integrated circuit includes: forming a first fin and a second fin comprising first and second semiconductor regions extending above a substrate; forming a first dielectric layer adjacent to a subfin portion of each of the first and second fins; forming sacrificial gates and spacer structures over the first fin and the second fin; removing portions of the first fin and the second fin not covered by the sacrificial gates and spacer structures; removing subfin portions of the first fin and the second fin to form subfin recesses; forming sacrificial plugs within the subfin recesses; forming a first source or drain region at exposed ends of the first semiconductor region and a second source or drain region at exposed ends of the second semiconductor region; removing the substrate to expose a backside of the sacrificial plugs; replacing the sacrificial plugs with a first conductive contact beneath the first source or drain region and a second conductive contact beneath the second source or drain region; forming a second dielectric layer beneath the first dielectric layer; and forming a conductive layer through the second dielectric layer and contacting both the first conductive contact and the second conductive contact.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a backside conductive layer beneath the transistors that extends between different source or drain regions. The backside conductive layer may be in a first backside interconnect layer while additional backside interconnect layers may be provided beneath the backside interconnect layer. One or more additional conductive layers may be provided within any of the additional backside interconnect layers, such as a power or ground rail.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

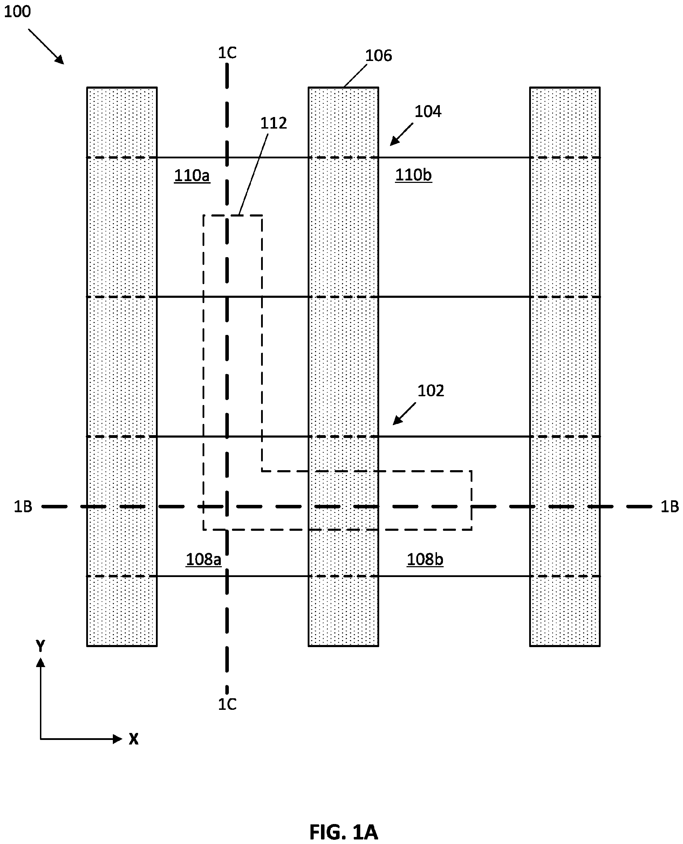

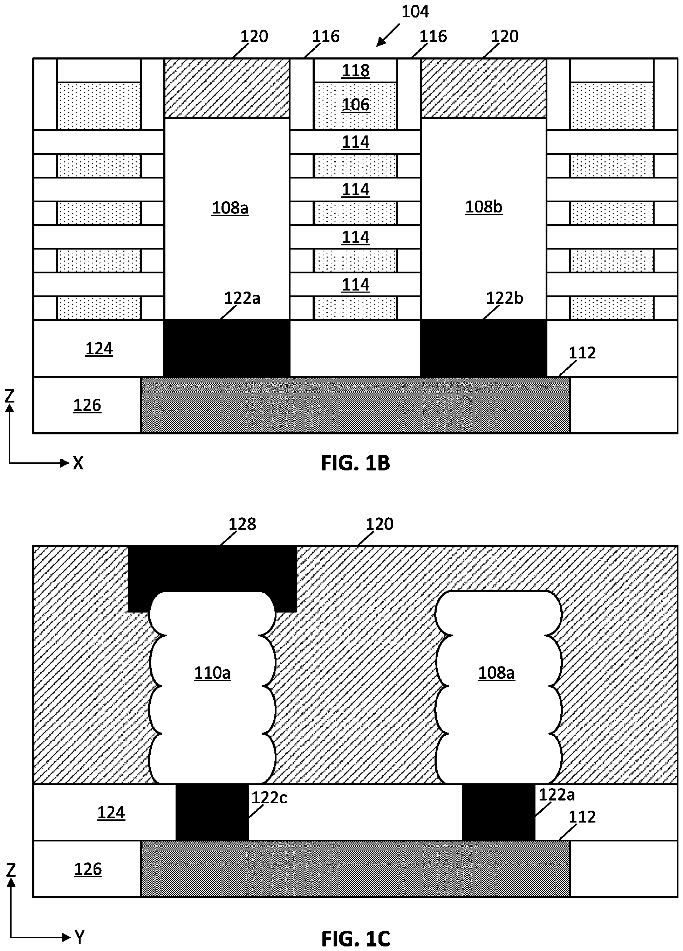

Figure 1A is top-down view of a portion of an integrated circuit 100 that includes various semiconductor devices, such as a first semiconductor device 102 and an adjacent second semiconductor device 104, in accordance with an embodiment of the present disclosure. Figure 1B illustrates a cross-section view across the XZ plane identified by the dashed line along the X-axis in Figure 1A, according to an embodiment. Figure 1C illustrates a cross-section view across the YZ plane identified by the dashed line along the Y-axis in Figure 1A, according to an embodiment. Each of the semiconductor devices may be non-planar metal oxide semiconductor (MOS) transistors, such as tri-gate (e.g., finFET) or gate-all-around (GAA) transistors, although other transistor topologies and types could also benefit from the techniques provided herein. The examples herein illustrate semiconductor devices with a GAA structure (e.g., having nanoribbons or nanowires that extend between source and drain regions).

The semiconductor devices 102/104 include semiconductor regions that extend in a first direction (e.g., along the X-axis) between corresponding source or drain regions with a gate structure 106 extending in a second direction (e.g., along the Y-axis) across the semiconductor regions. In the illustrated example, gate structure 106 covers the semiconductor regions extending between source or drain regions, but these regions can be seen in the cross-section view of Figure 1B. Any number of parallel gate structures 106 may be formed across the integrated circuit to form any number of transistors. According to some embodiments, first semiconductor device 102 and second semiconductor device 104 share the same gate structure 106. In some examples, a dielectric gate cut may separate gate structure 106 into separate sections for each of first semiconductor device 102 and second semiconductor device 104.

According to some embodiments, first semiconductor device 102 includes a semiconductor region extending along the first direction between a first source or drain region 108a and a second source or drain region 108b, and second semiconductor device 104 includes a semiconductor region extending along the first direction between a third source or drain region 110a and a fourth source or drain region 1 10b. Any semiconductor materials suitable for source and drain regions can be used (e.g., group IV and group III-V semiconductor materials) for any of the illustrated source or drains regions 108/110. In any such cases, the composition and doping of the source or drain regions may be the same or different, depending on the polarity of the transistors. In an example, first semiconductor device 102 is a NMOS device and first and second source or drain regions 108a/108b are doped with n-type dopants (e.g., phosphorous or arsenic), and second semiconductor device 104 is a PMOS device and third and fourth source or drain regions 110a/110b are doped with p-type dopants (e.g., boron). Any number of source and drain configurations and materials can be used.

According to some embodiments, a backside conductive layer 112 is provided beneath the source or drain regions to connect between any number of the source or drain regions. In the illustrated example, backside conductive layer 112 connects at least second source or drain region 108b with third source or drain region 110a. Backside conductive layer 112 may also connect second source or drain region 108b with first source or drain region 108a and/or third source or drain region 110a with first source or drain region 108a. Backside conductive layer 112 may include any suitable conductive material, such as tungsten, titanium, tantalum, ruthenium, molybdenum, or cobalt, or a nitride of any of these. According to some embodiments, backside conductive layer 112 may be patterned to have a non-linear shape to connect between source or drain regions that are not aligned along the X and Y axis. In the illustrated example, backside conductive layer 112 includes an 'L' shape with a first section extending along the first direction between first source or drain region 108a and second source or drain region 108b and a second section extending along the second direction between third source or drain region 110a and first source or drain region 108a. The first and second sections of backside conductive layer 112 may be patterned at the same time (e.g., a single mask) or may be patterned using two separate lithography processes (e.g., a first mask used to pattern the first section extending along the first direction and a second mask used to pattern the second section extending along the second direction).

Figures 1B and 1C provide more detailed cross-section views along both sections of backside conductive layer 112, according to some embodiments. Note that the same first source or drain region 108a is provided in each of the orthogonal cross-sections. Figure 1B illustrates the first section of backside conductive layer 112 extending beneath and between first source or drain region 108a and second source or drain region 108b. Also shown is the semiconductor region of second semiconductor device 104, which includes one or more nanoribbons 114, according to some embodiments. Nanoribbons 114 may be parts of fins that are formed of material deposited onto a substrate. The fins include alternating layers of material (e.g., alternating layers of silicon and SiGe) that facilitates forming of the nanowires or nanoribbons during a gate forming process where one type of the alternating layers is selectively etched away so as to liberate the other type of alternating layers within the channel region, so that a gate-all-around process can then be carried out. In other embodiments, a solid fin of semiconductor material (e.g., silicon or silicon germanium) is provided as the semiconductor region extending between first source or drain region 108a and second source or drain region 108b.

Gate structure 106 extends over nanoribbons 114 along second direction (e.g., along the Y-axis) to form the transistor gate. Gate structure 106 may include a gate dielectric and a gate electrode on the gate dielectric. The gate electrode may represent any number of conductive layers and the gate dielectric may represent any number of dielectric layers. The gate electrode may include any sufficiently conductive material such as a metal, metal alloy, or doped polysilicon. In some embodiments, the gate electrode includes one or more workfunction metals around nanoribbons 114. In some embodiments, p-channel devices include a workfunction metal having titanium around its one or more semiconductor regions and n-channel devices include a workfunction metal having tungsten around its one or more semiconductor regions. The gate electrode may also include a fill metal or other conductive material around the workfunction metals to provide the whole gate electrode structure. The gate dielectric may include any suitable gate dielectric material(s). In some embodiments, the gate dielectric includes a layer of native oxide material (e.g., silicon oxide) on nanoribbons 114 or other semiconductor regions, and a layer of high-k dielectric material (e.g., hafnium oxide) on the native oxide. According to some embodiments, spacer structures 116 are present along the sidewalls of gate structure 106. Spacer structures 116 may be any suitable dielectric material, such as silicon nitride, and provide separation between gate structure 106 and the adjacent source or drain regions 108a/108b. Spacer structures 116 may run along the gate structure sidewalls in the second direction and extend the entire height of gate structure 106 along the Z-axis. In some embodiments, a gate cap 118 is provided over gate structure 106 and may run along gate structure 106 in the second direction. Gate cap 118 may be any suitable dielectric material, such as silicon nitride. In some examples, gate cap 118 is the same dielectric material as spacer structures 116.

Figure 1C illustrates the second section of backside conductive layer 112 extending beneath and between first source or drain region 108a and third source or drain region 110a. The source/drain trench illustrated in Figure 1C may include a dielectric fill 120 around and/or over the various source or drain regions aligned within the source/drain trench. Dielectric fill 120 may also be seen over the top of first source or drain region 108a and second source or drain region 108b in Figure 1B. Dielectric fill 120 may include any suitable dielectric material, such as silicon dioxide.

According to some embodiments, backside contacts 122 are provided beneath any of the source or drain regions to facilitate electrical connection to backside conductive layer 112. In the illustrated example, a first backside contact 122a is provided beneath first source or drain region 110a, a second backside contact 122b is provided beneath second source or drain region 108b, and a third backside contact 122c is provided beneath third source or drain region 110a. Each of backside contacts 122 may include any suitable conductive material, such as tungsten, molybdenum, ruthenium, or cobalt. Backside contacts 122 may be formed using a self-aligned backside etch-and-replace process as will be discussed in more detail herein.

A first dielectric layer 124 may be provided beneath the semiconductor devices and around backside contacts 122, according to some embodiments. First dielectric layer 124 may be any suitable dielectric material, such as silicon dioxide. In some examples, backside contacts 122 extend through an entire thickness of first dielectric layer 124. A second dielectric layer 126 may be provided beneath first dielectric layer as part of a backside interconnect structure, according to some embodiments. Backside conductive layer 112 may extend through second dielectric layer 126 to contact the bottom surface of any number of backside contacts 122. Second dielectric layer 126 may be the same dielectric material as first dielectric layer 124 or any be any other suitable dielectric material.

According to some embodiments, a frontside conductive contact 128 is formed on the top surface of one or more source or drain regions. In the illustrated example, frontside conductive contact 128 is formed on the top surface of third source or drain region 110a. Frontside conductive contact 128 may include any suitable conductive material, such as tungsten, titanium, tantalum, ruthenium, molybdenum, or cobalt, or a nitride of any of these.

In the illustrated example, backside conductive layer 112 provides electrical connection between each of first source or drain region 108a, second source or drain region 108b, and third source or drain region 110a. However, in some embodiments, first backside contact 122a is omitted such that backside conductive layer 112 "flies under" first source or drain region 108a to provide electrical connection only between second source or drain region 108b and third source or drain region 110a.

### Fabrication Methodology

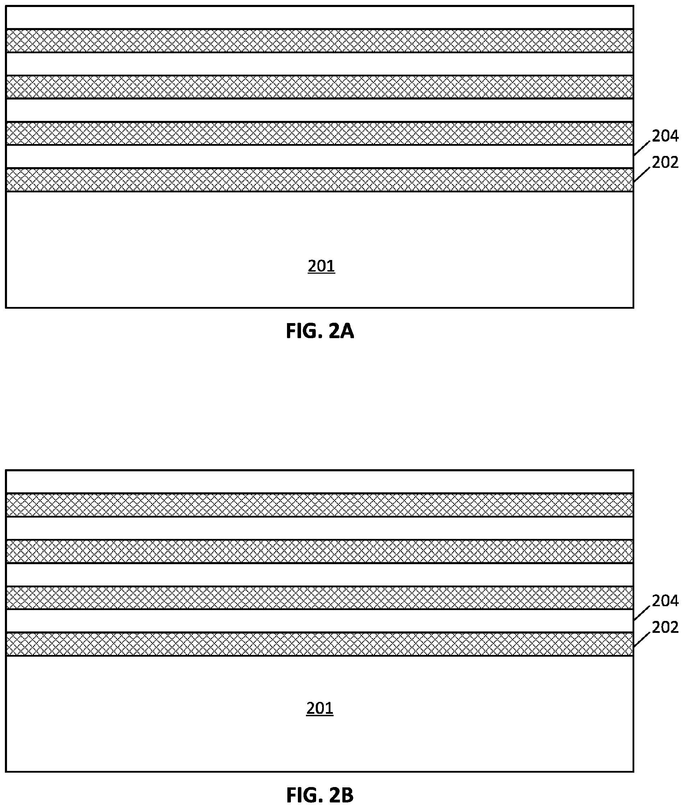

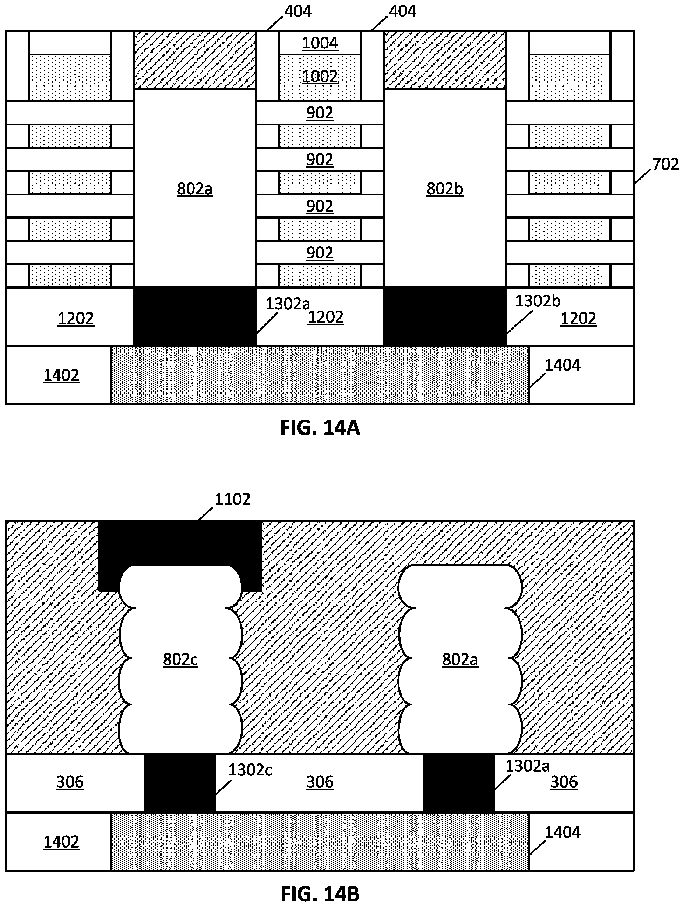

Figures 2A - 14A and 2B - 14B include cross-sectional views that collectively illustrate an example process for forming an integrated circuit configured with a backside conductive layer coupled between different source or drain regions, in accordance with an embodiment of the present disclosure. Figures 2A - 14A represent a similar cross-sectional view taken across the XZ plane in Figure 1B, while Figures 2B - 14B represent a cross-sectional view taken across the YZ in Figure 1C. Each set of figures sharing the same letter shows an example structure that results from the process flow up to that point in time, so the depicted structure evolves as the process flow continues, culminating in the structure shown in Figures 14A - 14B, which is similar to the structure shown in Figures 1B and 1C. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figures 2A and 2B each illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202.

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

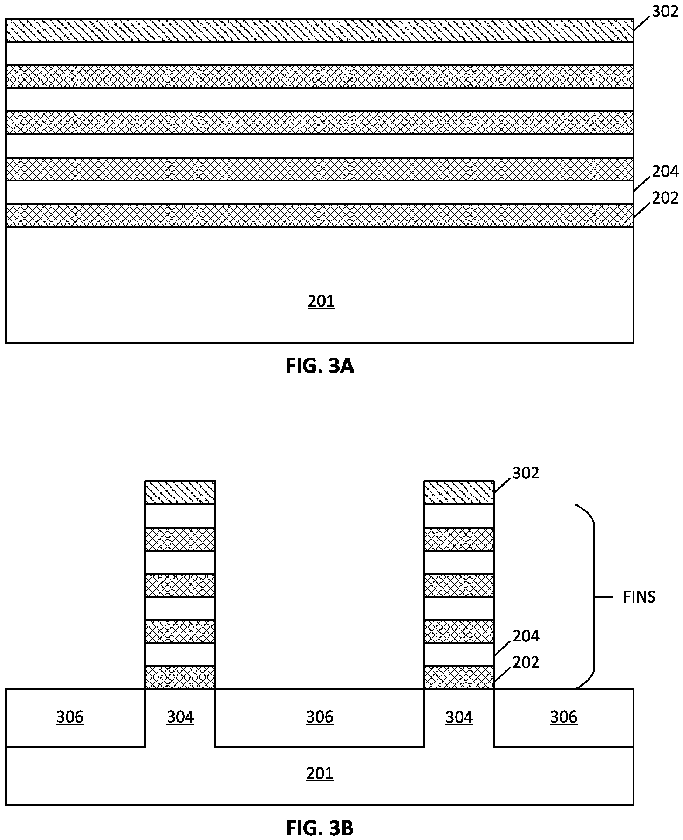

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction, as seen in Figure 3A.

According to some embodiments, an anisotropic etching process through the layer stack continues into at least a portion of substrate 201. Portions of substrate 201 beneath the fins are not etched and yield subfin regions 304. The etched portion of substrate 201 may be filled with a dielectric layer 306 that acts as shallow trench isolation (STI) between adjacent fins. Dielectric layer 306 may be any suitable dielectric material such as silicon oxide. Subfin regions 304 represent remaining portions of substrate 201 between dielectric layer 306, according to some embodiments.

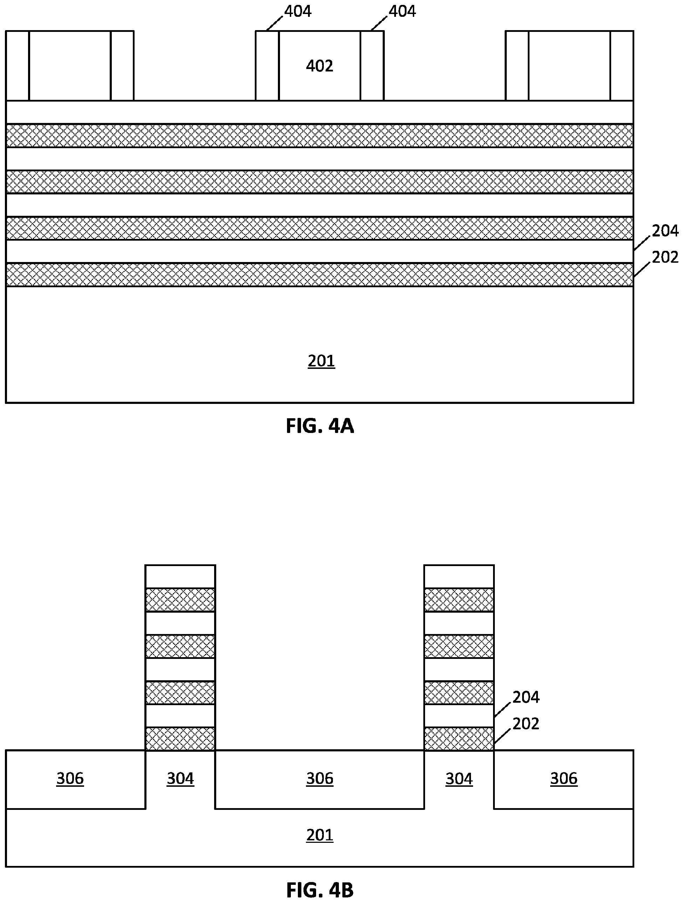

Figures 4A and 4B depict cross-section views of the structures shown in Figures 3A and 3B following the formation of sacrificial gates 402, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any suitable material that can be selectively removed without damaging the semiconductor material of the fins. In some examples, sacrificial gate 402 includes polysilicon.

According to some embodiments, spacer structures 404 are formed along the sidewalls of sacrificial gates 402. Spacer structures 404 may be deposited and then etched back such that spacer structures 404 remain mostly only on sidewalls of any exposed structures. In the cross-section view of Figure 4B, spacer structures 404 may also be formed along sidewalls of the exposed fins over dielectric layer 306. Such sidewall spacers on the fins can be removed during later processing when forming the source or drain regions. According to some embodiments, spacer structures 404 may be any suitable dielectric material, such as silicon nitride, silicon carbon nitride, or silicon oxycarbonitride. In one such embodiment, spacer structures 404 comprise a nitride and dielectric layer 306 comprises an oxide, so as to provide a degree of etch selectivity during final gate processing. Other etch selective dielectric schemes (e.g., oxide/carbide, carbide/nitride) can be used as well for spacer structures 404 and dielectric layer 306. In other embodiments, spacer structures 404 and dielectric layer 306 are compositionally the same or otherwise similar, where etch selectivity is not employed.

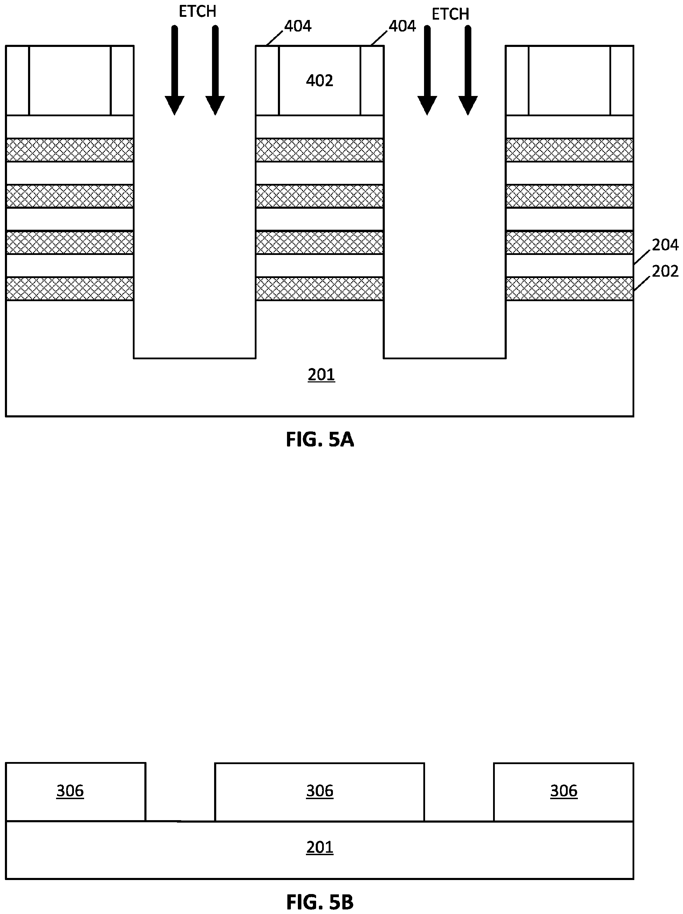

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE). The removal of the exposed fin portions creates source or drain trenches that alternate with gate trenches (currently filled with sacrificial gates 402) along the first direction, according to some embodiments.

According to some embodiments, a portion of substrate 201 is also removed during the etching process to form recessed regions below a top surface of substrate 201. In some examples, at least a portion of subfin regions 304 are removed such that a top surface of subfin regions 304 is recessed below a top surface of dielectric layer 306. In the illustrated example, the entire subfin regions 304 are removed. In some examples, the etch proceeds further into substrate 201 such that bottom surface of the recesses are below a bottom surface of dielectric layer 306.

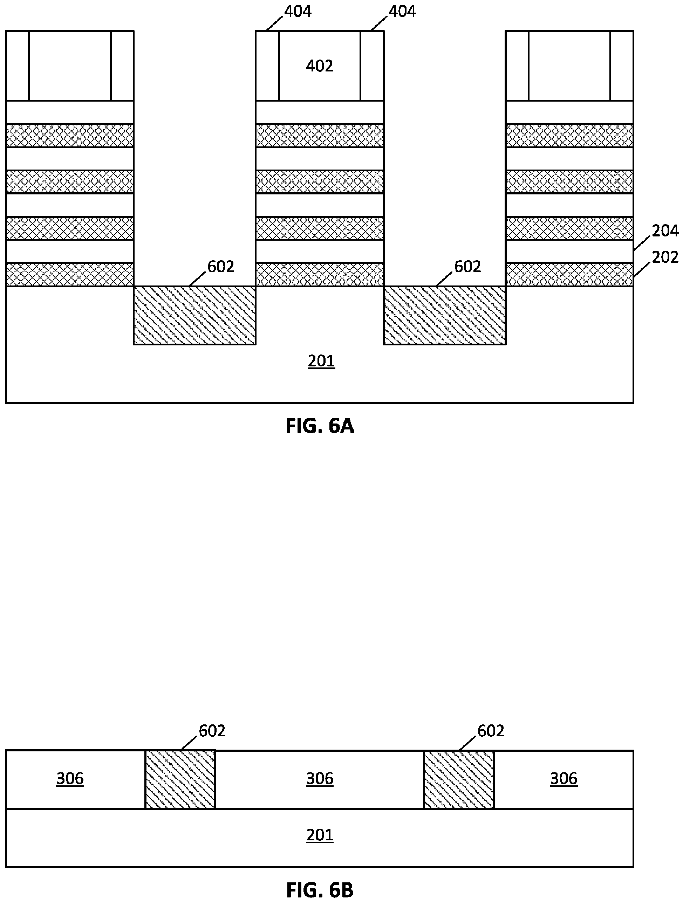

Figures 6A and 6B depict cross-section views of the structures shown in Figures 5A and 5B following the formation of sacrificial plugs 602 at the bottom of the etched recesses, according to some embodiments. Sacrificial plugs 602 may include any suitable material that can be safely removed at a later time without damaging or substantially etching surrounding dielectric, metal, and/or semiconductor materials. In one example, sacrificial plugs 602 include aluminum oxide. According to some embodiments, sacrificial material is deposited within the openings formed by the previous etching process and is recessed down to a final height using any suitable isotropic etching process. According to some embodiments, sacrificial plugs 602 have a top surface that is substantially coplanar with a top surface of dielectric layer 306 and/or substrate 201. In some examples, the top surface of sacrificial plugs 602 is below the top surface of dielectric layer 306 and/or substrate 201.

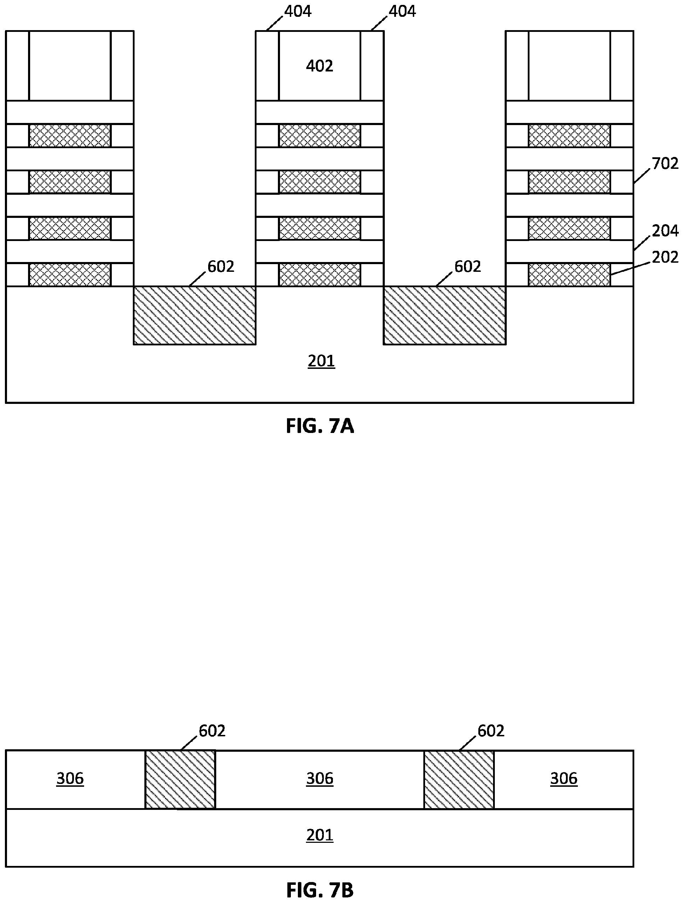

Figures 7A and 7B depict cross-section views of the structures shown in Figures 6A and 6B following the removal of portions of sacrificial layers 202 and subsequent formation of internal spacers 702, according to an embodiment of the present disclosure. An isotropic etching process may be used to selectively recess the exposed ends of each sacrificial layer 202 (e.g., while etching comparatively little of semiconductor layers 204). Internal spacers 702 may have a material composition that is similar to or the exact same as spacer structures 404. Accordingly, internal spacers 702 may be any suitable dielectric material that exhibits high etch selectively to semiconductor materials such as silicon and/or silicon germanium. Internal spacers 702 may be, for example, conformally deposited over the sides of the fin structure using a conformal deposition process like CVD or ALD and then etched back using an isotropic etching process to expose the ends of semiconductor layers 204. According to some embodiments, internal spacers 702 have a similar width (e.g., along the first direction) to spacer structures 404.

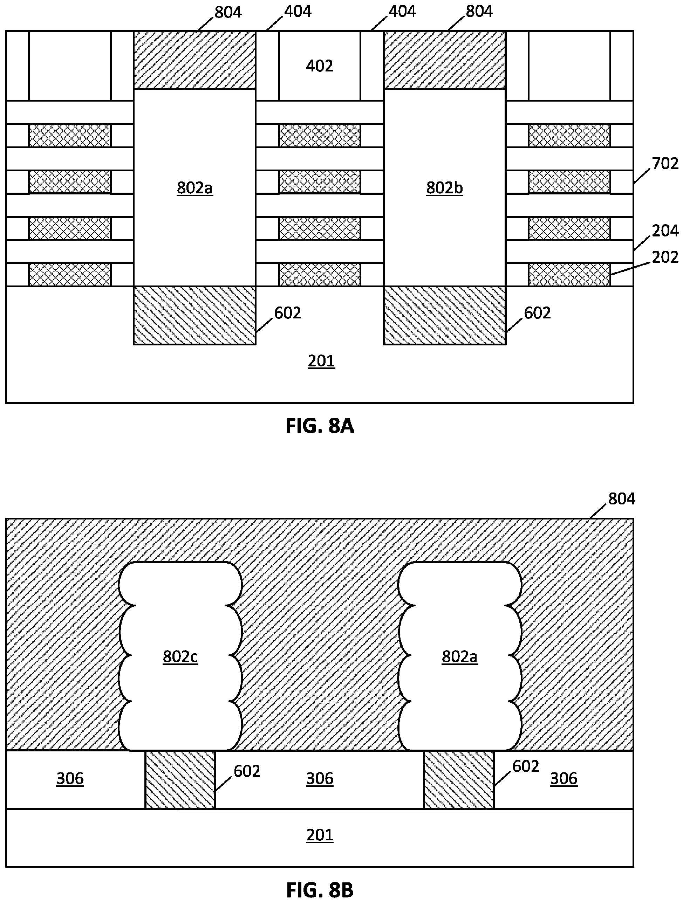

Figures 8A and 8B depict cross-section views of the structure shown in Figures 7A and 7B, respectively, following the formation of source or drain regions 802 within the source/drain trenches, according to some embodiments. The source or drain regions may be formed in the areas that had been previously occupied by the exposed fins between spacer structures 404. According to some embodiments, a first semiconductor device includes a first source or drain region 802a and a second source or drain region 802b as illustrated in Figure 8A. First source or drain region 802a is also seen in the orthogonal cross-section of Figure 8B and is adjacent to a third source or drain region 802c from a second semiconductor device.

According to some embodiments, source or drain regions 802 are epitaxially grown from the exposed semiconductor material at the ends of semiconductor layers 204. In some example embodiments, first and second source or drain regions 802a/802b are NMOS source or drain regions (e.g., epitaxial silicon), and third source or drain region 802c is a PMOS source or drain region (e.g., epitaxial SiGe).

According to some embodiments, a dielectric fill 804 is provided within the source/drain trench. In some examples, dielectric fill 804 occupies a remaining volume within the source/drain trench around and over source or drain regions 802. Dielectric fill 804 may be any suitable dielectric material, such as silicon dioxide. In some examples, dielectric fill 804 extends up to and planar with a top surface of spacer structures 404 (e.g., following a polishing procedure) as seen in Figure 8A.

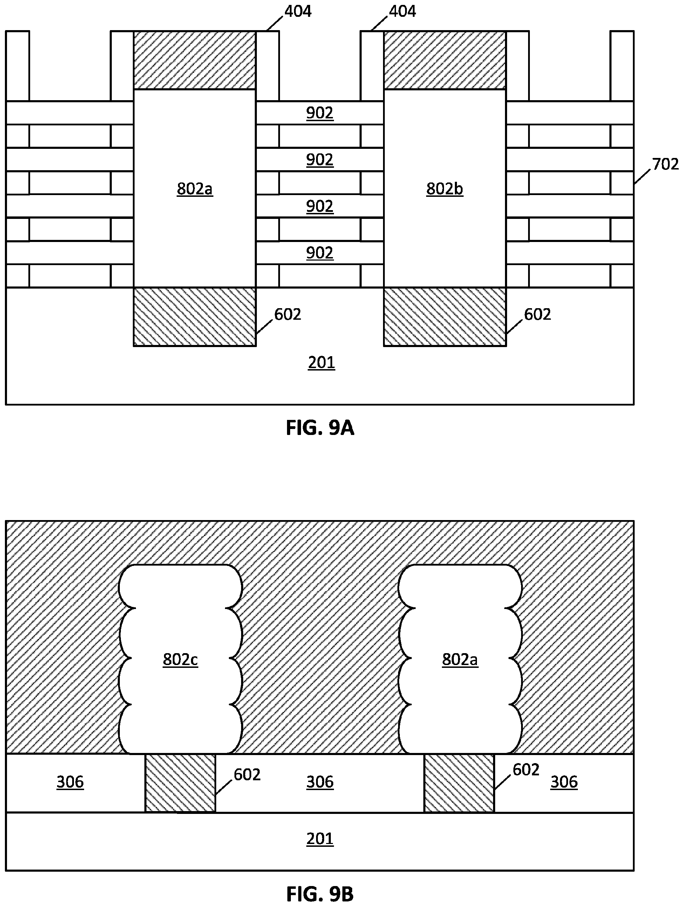

Figures 9A and 9B depict cross-section views of the structure shown in Figures 8A and 8B, respectively, following the removal of sacrificial gates 402 and sacrificial layers 202, according to some embodiments. In examples where gate masking layers are still present, they would be removed at this time. Once sacrificial gates 402 are removed, the fins extending between spacer structures 404 are exposed.

In the example where the fins include alternating semiconductor layers, sacrificial layers 202 are selectively removed to leave behind nanoribbons 902 that extend between corresponding source or drain regions (such as between first source or drain region 802a and second source or drain region 802b). Each vertical set of nanoribbons 902 represents the semiconductor region of a different semiconductor device. It should be understood that nanoribbons 902 may also be nanowires or nanosheets. Sacrificial gates 402 and sacrificial layers 202 may be removed using the same isotropic etching process or different isotropic etching processes.

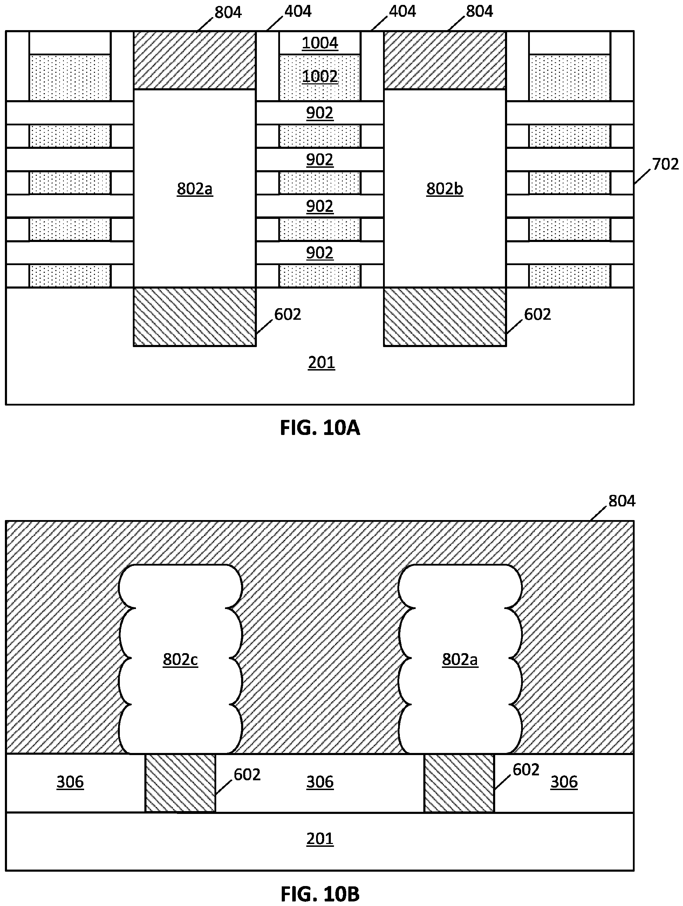

Figures 10A and 10B depict cross-section views of the structure shown in Figures 9A and 9B, respectively, following the formation of a gate structure 1002, which includes a gate dielectric and a gate electrode, and a subsequent gate cap 1004, according to some embodiments. The gate dielectric may be first formed around nanoribbons 902 prior to the formation of the gate electrode, which may include one or more conductive layers. The gate dielectric may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 902, and a second layer on the first layer. The first layer can be, for instance, an oxide of the semiconductor material of nanoribbons 902 (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Gate cap 1004 may be formed by first recessing the gate electrode and filling the recess with a dielectric material. The dielectric material may then be polished such that its top surface is substantially coplanar with a top surface of spacer structures 404 and/or dielectric fill 804.

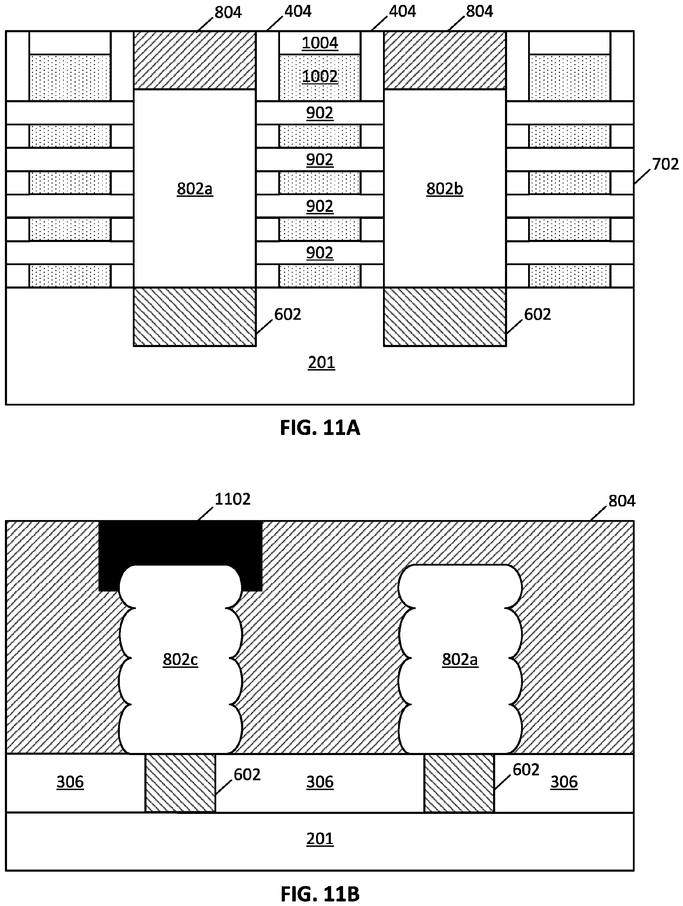

Figures 11A and 11B depict cross-section views of the structure shown in Figures 10A and 10B, respectively, following the formation of a frontside conductive contact 1102 within the source/drain trench and on any number of source or drain regions, according to some embodiments. In the illustrated example, a single frontside conductive contact 1102 is formed over third source or drain region 802c. Frontside conductive contact 1102 may include any suitable conductive material, such as tungsten, molybdenum, ruthenium, or cobalt for making electrical contact with the underlying third source or drain region 802c. As seen in the cross section of Figure 11B, a portion of dielectric fill 804 is recessed to expose at least the top surface of third source or drain region 802c and frontside conductive contact 1102 is formed within the recess using any suitable metal deposition process. According to some embodiments, frontside conductive contact 1102 includes one or more silicide layers directly on the exposed surface of third source or drain region 802c.

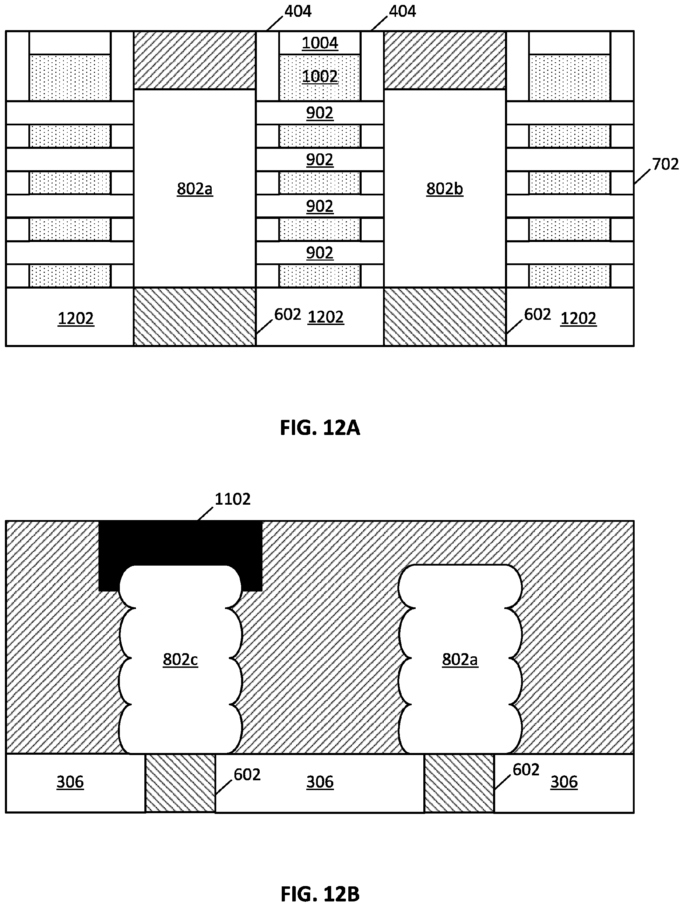

Figures 12A and 12B depict cross-section views of the structure shown in Figures 11A and 11B, respectively, following the removal of a bulk portion of substrate 201, according to some embodiments. Substrate 201 may be removed from the backside via any combination of grinding, polishing, and/or etching processes. In some embodiments, substrate 201 may continue to be thinned from the backside until bottom surfaces of dielectric layer 306 or sacrificial plugs 602 are exposed. In some examples, the backside polishing process may continue until at least both bottom surfaces of dielectric layer 306 and sacrificial plugs 602 are exposed.

Portions of substrate 201 may remain between sacrificial plugs 602 along the first direction. According to some embodiments, an isotropic etching process may be used to remove the exposed semiconductor material from the remaining portions of substrate 201. The areas left behind following this removal of the substrate portions may then be filled with a first backside dielectric layer 1202. In some embodiments, first backside dielectric layer 1202 includes the same material as dielectric layer 306, such that there is little to no discernable difference between them. First backside dielectric layer 1202 may be any suitable dielectric material, such as silicon dioxide, silicon nitride, or silicon oxynitride. According to some embodiments, first backside dielectric layer 1202 is polished following its deposition such that a bottom surface of first backside dielectric layer 1202 is substantially coplanar with a bottom surface of sacrificial plugs 602.

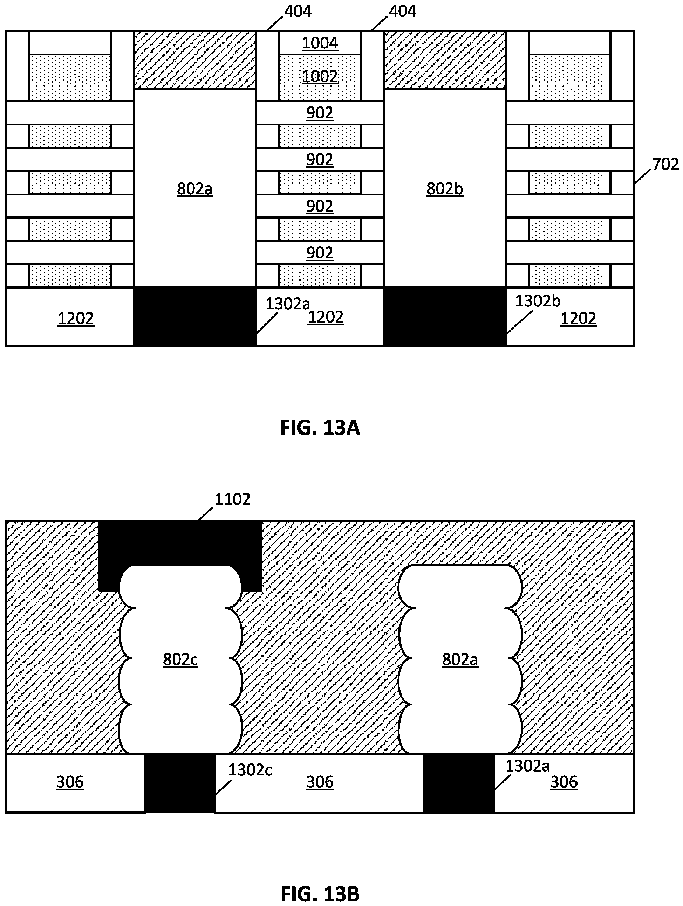

Figures 13A and 13B depict cross-section views of the structure shown in Figures 12A and 12B, respectively, following the backside removal of sacrificial plugs 602 and subsequent formation of backside contacts 1302, according to some embodiments. Sacrificial plugs 602 may be removed using any suitable isotropic etching process that removes the sacrificial material but removes none, or very little, of any exposed dielectric, metal, or semiconductor material. The removal of sacrificial plugs 602 leaves behind backside recesses beneath the source or drain regions 802. According to some embodiments, backside contacts 1302 are formed within the backside recesses and on a bottom surface of corresponding source or drain regions 802. In the illustrated example, a first backside contact 1302a is formed beneath first source or drain region 802a, a second backside contact 1302b is formed beneath second source or drain region 802b, and a third backside contact 1302c is formed beneath third source or drain region 802c. Backside contacts 1302 may include any suitable conductive material, such as tungsten, molybdenum, ruthenium, or cobalt.

Figures 14A and 14B depict cross-section views of the structure shown in Figures 13A and 13B, respectively, following the formation of a second backside dielectric layer 1402 and a backside conductive layer 1404 through second backside dielectric layer 1402, according to some embodiments. Second backside dielectric layer 1402 may be any suitable dielectric material, and may be the same dielectric material as first backside dielectric layer 1202 and dielectric layer 306. According to some embodiments, any suitable lithography technique is used to form a recess through second backside dielectric layer 1402, thus exposing the bottom surfaces of backside contacts 1302, and forming a conductive material within the recess to form backside conductive layer 1404.

Due to the presence of backside contacts 1302a - 1302c, backside conductive layer 1404 provides electrical connection between each of first source or drain region 802a, second source or drain region 802b, and third source or drain region 802c, according to some embodiments. Accordingly, backside conductive layer 1404 may include a first section extending in the first direction (as seen in Figure 14A) and a second section extending in the second direction (as seen in Figure 14B) with both sections connected at a common point beneath first backside contact 1302a. In some embodiments, first backside contact 1302a is omitted (e.g., the area is instead occupied with one or more dielectric materials), such that backside conductive layer 1404 electrically connects second source or drain region 802b only with third source or drain region 802c while extending or "flying" under first source or drain region 802a without contacting same. Any other interconnect arrangements may be provided, as will be appreciated. Backside conductive layer 1404 may include any suitable conductive material, such as tungsten, titanium, tantalum, ruthenium, molybdenum, or cobalt, or a nitride of any of these.

As noted above, backside conductive layer 1404 may be formed using a single mask process or a multiple-mask process. For example, in the single mask process, the recess for the first and second sections of backside conductive layer 1404 is formed at one time (e.g., using a single mask to form an 'L' shaped recess through second backside dielectric layer 1402). According to another example, a first mask is used to pattern a first section of the recess extending along the first direction while a second mask is used to pattern a second section of the recess extending along the second direction. In either case, backside conductive layer 1404 may be formed in the resulting recess through second backside dielectric layer 1402.

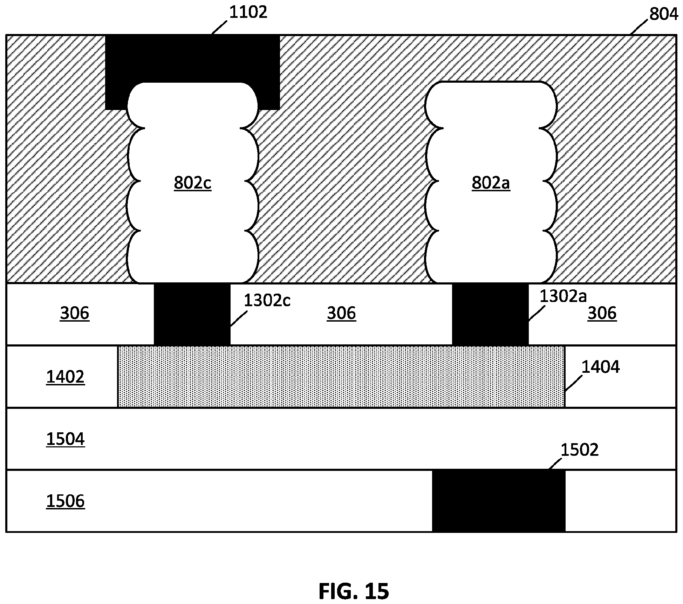

Additional backside conductive layers, such as those that carry power or ground rails, may be provided in lower backside interconnect layers. Figure 15 illustrates an example of the structure shown in Figure 14B with a third backside dielectric layer 1504, a fourth backside dielectric layer 1506, and a second backside conductive layer 1502, according to some embodiments. Each of third backside dielectric layer 1504 and fourth backside dielectric layer 1506 may be any suitable dielectric material, and may be the same dielectric material as second backside dielectric layer 1402 and dielectric layer 306. Second backside conductive layer 1502 may include any suitable conductive material, such as tungsten, tungsten nitride, titanium, titanium nitride, tantalum, ruthenium, molybdenum, or cobalt.

According to some embodiments, second backside conductive layer 1502 may be used to supply a power or ground rail to the semiconductor devices. The presence of backside conductive layer 1404 relegates second backside conductive layer 1502 to a lower position within the backside interconnect region to avoid any shorting between the conductive layers, according to some embodiments. Any source or drain region may be coupled to second backside conductive layer 1502 using one or more vias that pass through the thickness of each of dielectric layer 306, second backside dielectric layer 1402, and third backside dielectric layer 1504.

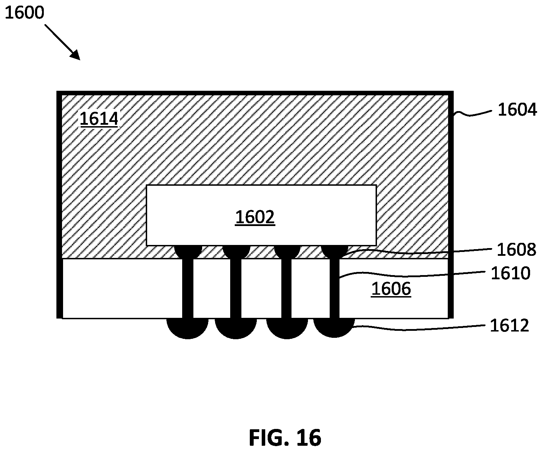

Figure 16 illustrates an example embodiment of a chip package 1600, in accordance with an embodiment of the present disclosure. As can be seen, chip package 1600 includes one or more dies 1602. One or more dies 1602 may include at least one integrated circuit having semiconductor devices, such as any of the semiconductor devices disclosed herein. One or more dies 1602 may include any other circuitry used to interface with other devices formed on the dies, or other devices connected to chip package 1600, in some example configurations.

As can be further seen, chip package 1600 includes a housing 1604 that is bonded to a package substrate 1606. The housing 1604 may be any standard or proprietary housing, and may provide, for example, electromagnetic shielding and environmental protection for the components of chip package 1600. The one or more dies 1602 may be conductively coupled to a package substrate 1606 using connections 1608, which may be implemented with any number of standard or proprietary connection mechanisms, such as solder bumps, ball grid array (BGA), pins, or wire bonds, to name a few examples. Package substrate 1606 may be any standard or proprietary package substrate, but in some cases includes a dielectric material having conductive pathways (e.g., including conductive vias and lines) extending through the dielectric material between the faces of package substrate 1606, or between different locations on each face. In some embodiments, package substrate 1606 may have a thickness less than 1 millimeter (e.g., between 0.1 millimeters and 0.5 millimeters), although any number of package geometries can be used. Additional conductive contacts 1612 may be disposed at an opposite face of package substrate 1606 for conductively contacting, for instance, a printed circuit board (PCB). One or more vias 1610 extend through a thickness of package substrate 1606 to provide conductive pathways between one or more of connections 1608 to one or more of contacts 1612. Vias 1610 are illustrated as single straight columns through package substrate 1606 for ease of illustration, although other configurations can be used (e.g., damascene, dual damascene, through-silicon via, or an interconnect structure that meanders through the thickness of substrate 1606 to contact one or more intermediate locations therein). In still other embodiments, vias 1610 are fabricated by multiple smaller stacked vias, or are staggered at different locations across package substrate 1606. In the illustrated embodiment, contacts 1612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1612, to inhibit shorting.

In some embodiments, a mold material 1614 may be disposed around the one or more dies 1602 included within housing 1604 (e.g., between dies 1602 and package substrate 1606 as an underfill material, as well as between dies 1602 and housing 1604 as an overfill material). Although the dimensions and qualities of the mold material 1614 can vary from one embodiment to the next, in some embodiments, a thickness of mold material 1614 is less than 1 millimeter. Example materials that may be used for mold material 1614 include epoxy mold materials, as suitable. In some cases, the mold material 1614 is thermally conductive, in addition to being electrically insulating.

### Methodology

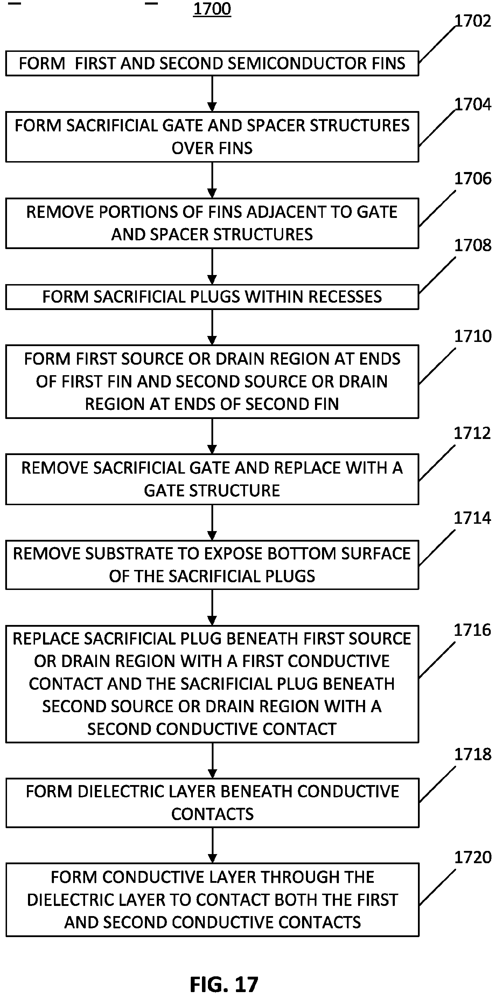

Figure 17 is a flow chart of a method 1700 for forming at least a portion of an integrated circuit, according to an embodiment. Various operations of method 1700 may be illustrated in Figures 2A - 14A and 2B - 14B. However, the correlation of the various operations of method 1700 to the specific components illustrated in the aforementioned figures is not intended to imply any structural and/or use limitations. Rather, the aforementioned figures provide one example embodiment of method 1700. Other operations may be performed before, during, or after any of the operations of method 1700. For example, method 1700 does not explicitly describe various standard processes that are usually performed to form transistor structures. Some of the operations of method 1700 may be performed in a different order than the illustrated order.

Method 1700 begins with operation 1702 where a plurality of parallel semiconductor fins, including at least a first and second fin, are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

Method 1700 continues with operation 1704 where sacrificial gates are formed over the fins. The sacrificial gates may be patterned using gate masking layers in strips that run orthogonally over the fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may be any suitable dielectric material, such as silicon nitride or silicon oxynitride.

Method 1700 continues with operation 1706 where portions of the fins adjacent to the sacrificial gate and spacer structures (e.g., not covered by the sacrificial gate and spacer structures) are removed. Any exposed portions of the fins not covered by the sacrificial gates or spacer structures may be removed using any anisotropic etching process, such as reactive ion etching (RIE). According to some embodiments, the etch continues past the height of the fins into the substrate such that recesses are etched into the substrate between the remaining portions of the fins.

Method 1700 continues with operation 1708, where sacrificial plugs are formed within the recesses. According to some embodiments, a sacrificial material is deposited over the entire structure and recessed using any suitable isotropic etching process until the material remains only within the recesses etched into the substrate material. The sacrificial material may include any suitable material that can be safely removed at a later time, such as aluminum oxide.

Method 1700 continues with operation 1710 where source or drain regions are formed at the exposed ends of the first and second fins. The source or drain regions may be formed in the areas that had been previously occupied by the exposed fins between the spacer structures. According to some embodiments, the source or drain regions are epitaxially grown from the exposed semiconductor material of the fins (or nanoribbons, nanowires or nanosheets, as the case may be) along the exterior walls of the spacer structures. In some example embodiments, the source or drain regions are NMOS source or drain regions (e.g., epitaxial silicon) or PMOS source or drain regions (e.g., epitaxial SiGe). A dielectric fill may formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth. According to some embodiments, the source or drain regions are grown directly over the sacrificial plugs, such that a bottom surface of the source or drain regions may contact a top surface of the sacrificial plugs.

Method 1700 continues with operation 1712 where gate structures are formed over the semiconductor material of the various semiconductor fins. The sacrificial gates are first removed along with any sacrificial layers within the exposed fins between the spacer structures (in the case of GAA structures). The gate structures may then be formed in place of the sacrificial gates. The gate structures may each include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

According to some embodiments, a portion of the dielectric fill within the source/drain trench may be recessed at least until a top surface of a given source or drain region in the trench is exposed. A frontside conductive contact may be formed within the recess in the source/drain trench such that the frontside conductive contact touches the top surface of given source or drain region in the trench. Separate frontside conductive contacts may be formed within the trench over corresponding source or drain regions, or a frontside conductive contact may extend along the second direction within the trench to contact any number of source or drain regions. The frontside conductive contact may include any suitable conductive material, such as tungsten, molybdenum, ruthenium, or cobalt.

Method 1700 continues with operation 1714 where the substrate is removed from the backside of the structure. The substrate may be removed via any combination of grinding, polishing, and/or etching processes. In some embodiments, the substrate is thinned away at least until bottom surfaces of the sacrificial plugs are exposed. In some examples, the only portions of the semiconductor material from the substrate left behind following the backside polishing process are between the sacrificial plugs along the first direction. These remaining substrate portions may be removed via a suitable isotropic etching process and replaced with one or more dielectric layers.

Method 1700 continues with operation 1716 where the sacrificial plugs beneath the first and second source or drain regions are replaced with corresponding backside contacts. The sacrificial plugs may be removed using any suitable isotropic etching process that removes the sacrificial material but removes none, or very little, of any exposed dielectric, metal, or semiconductor material. The removal of the sacrificial plugs leaves behind backside recesses beneath the source or drain regions. According to some embodiments, the backside contacts are formed within the backside recesses and on a bottom surface of corresponding source or drain regions. The backside contacts may include any suitable conductive material, such as tungsten, molybdenum, ruthenium, or cobalt.

Method 1700 continues with operation 1718 where a backside dielectric layer is formed beneath the conductive contacts. The backside dielectric layer may include any suitable dielectric material, such as silicon dioxide, silicon nitride, or silicon oxynitride. The backside dielectric layer may be one layer of a plurality of backside dielectric layers that make up a backside interconnect region.

Method 1700 continues with operation 1720 where a conductive layer is formed through the backside dielectric layer and contacting one or more of the backside conductive contacts. According to some embodiments, the backside conductive layer electrically connects any number of different source or drain regions together via their corresponding backside contacts. According to some embodiments, any suitable lithography technique is used to form a recess through the backside dielectric layer, thus exposing the bottom surfaces of any number of backside contacts, and forming a conductive material within the recess to form the backside conductive layer coupled to the backside contacts. The backside conductive layer may be used to provide electrical connection between two source or drain regions that are not aligned along the first direction and are not aligned along the second direction. In some examples, the backside conductive layer may extend beneath any number of source or drain regions without electrically connecting to them (e.g., source or drain regions without a corresponding backside contact).

### Example System

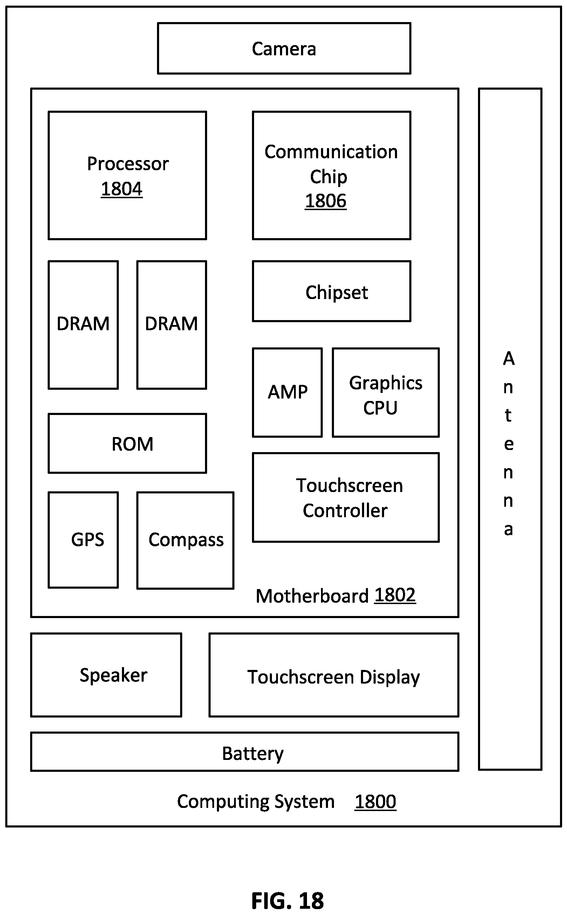

FIG. 18 is an example computing system implemented with one or more of the integrated circuit structures as disclosed herein, in accordance with some embodiments of the present disclosure. As can be seen, the computing system 1800 houses a motherboard 1802. The motherboard 1802 may include a number of components, including, but not limited to, a processor 1804 and at least one communication chip 1806, each of which can be physically and electrically coupled to the motherboard 1802, or otherwise integrated therein. As will be appreciated, the motherboard 1802 may be, for example, any printed circuit board (PCB), whether a main board, a daughterboard mounted on a main board, or the only board of system 1800, etc.

Depending on its applications, computing system 1800 may include one or more other components that may or may not be physically and electrically coupled to the motherboard 1802. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1800 may include one or more integrated circuit structures or devices configured in accordance with an example embodiment (e.g., a module including an integrated circuit device on a substrate, the substrate having one or more semiconductor devices that include logic connections made through a backside conductive layer). In some embodiments, multiple functions can be integrated into one or more chips (e.g., for instance, note that the communication chip 1806 can be part of or otherwise integrated into the processor 1804).

The communication chip 1806 enables wireless communications for the transfer of data to and from the computing system 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1800 may include a plurality of communication chips 1806. For instance, a first communication chip 1806 may be dedicated to shorter range wireless communications such as Wi-Fi and Bluetooth and a second communication chip 1806 may be dedicated to longer range wireless communications such as GPS, EDGE, GPRS, CDMA, WiMAX, LTE, Ev-DO, and others.

The processor 1804 of the computing system 1800 includes an integrated circuit die packaged within the processor 1804. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1806 also may include an integrated circuit die packaged within the communication chip 1806. In accordance with some such example embodiments, the integrated circuit die of the communication chip includes one or more semiconductor devices as variously described herein. As will be appreciated in light of this disclosure, note that multistandard wireless capability may be integrated directly into the processor 1804 (e.g., where functionality of any chips 1806 is integrated into processor 1804, rather than having separate communication chips). Further note that processor 1804 may be a chip set having such wireless capability. In short, any number of processor 1804 and/or communication chips 1806 can be used. Likewise, any one chip or chip set can have multiple functions integrated therein.

In various implementations, the computing system 1800 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1800 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region, a second semiconductor device having a second semiconductor region extending in the first direction from a second source or drain region, a first conductive contact on an underside of the first source or drain region, a second conductive contact on an underside of the second source or drain region, and a backside conductive layer coupled between the first conductive contact and the second conductive contact.

Example 2 includes the integrated circuit of Example 1, wherein the first semiconductor device includes a gate structure extending over the first semiconductor region along a second direction and the second semiconductor device includes the gate structure extending over the second semiconductor region along the second direction, the second direction being substantially orthogonal to the first direction.

Example 3 includes the integrated circuit of Example 1, wherein the first semiconductor device includes a first gate structure extending over the first semiconductor region along a second direction and the second semiconductor device includes a second gate structure extending over the second semiconductor region along the second direction and parallel to the first gate structure, the second direction being substantially orthogonal to the first direction.

Example 4 includes the integrated circuit of any one of Examples 1-3, further comprising a frontside contact on a top surface of the first source or drain region or the second source or drain region.

Example 5 includes the integrated circuit of any one of Examples 1-4, further comprising a dielectric layer beneath the first source or drain region and the second source or drain region, such that the first conductive contact and the second conductive contact extend through an entire thickness of the dielectric layer.

Example 6 includes the integrated circuit of Example 5, wherein the dielectric layer is a first dielectric layer and the integrated circuit further comprises a second dielectric layer beneath the first dielectric layer, wherein the backside conductive layer extends through the second dielectric layer.

Example 7 includes the integrated circuit of Example 6, wherein the backside conductive layer is a first backside conductive layer and the integrated circuit further includes one or more additional dielectric layers beneath the second dielectric layer, and a second backside conductive layer extending through one of the one or more additional dielectric layers.

Example 8 includes the integrated circuit of any one of Examples 1-7, wherein the first source or drain region is an n-type source or drain region and the second source or drain region is a p-type source or drain region.

Example 9 includes the integrated circuit of any one of Examples 1-8, wherein the backside conductive layer includes a first section that extends lengthwise along the first direction and a second section that extends lengthwise along a second direction, the second direction being substantially orthogonal to the first direction.

Example 10 includes the integrated circuit of Example 9, wherein the first section of the backside conductive layer contacts the first conductive contact and the second section of the backside conductive layer contacts the second conductive contact.

Example 11 is a printed circuit board that includes the integrated circuit of any one of Examples 1-10.

Example 12 is an electronic device that includes a chip package having one or more dies. At least one of the one or more dies includes a first source or drain region as part of a first semiconductor device, a second source or drain region as part of a second semiconductor device, a first conductive contact on an underside of the first source or drain region and a second conductive contact on an underside of the second source or drain region, and a backside conductive layer coupled between the first conductive contact and the second conductive contact.

Example 13 includes the electronic device of Example 12, wherein the at least one of the one or more dies further comprises a first semiconductor region extending from the first source or drain region along a first direction, a second semiconductor region extending from the second source or drain region along the first direction, and a gate structure extending over the first semiconductor region and the second semiconductor region along a second direction substantially orthogonal to the first direction.

Example 14 includes the electronic device of Example 12, wherein the at least one of the one or more dies further comprises a first semiconductor region extending from the first source or drain region along a first direction, a second semiconductor region extending from the second source or drain region along the first direction, a first gate structure extending over the first semiconductor region along a second direction substantially orthogonal to the first direction, and a second gate structure extending over the second semiconductor region along the second direction.

Example 15 includes the electronic device of any one of Examples 12-14, wherein the at least one of the one or more dies further comprises a frontside contact on a top surface of the first source or drain region or the second source or drain region.

Example 16 includes the electronic device of any one of Examples 12-15, wherein the at least one of the one or more dies further comprises a dielectric layer beneath the first source or drain region and the second source or drain region, such that the first conductive contact and the second conductive contact extend through an entire thickness of the dielectric layer.

Example 17 includes the electronic device of Example 16, wherein the dielectric layer is a first dielectric layer and the at least one of the one or more dies further comprises a second dielectric layer beneath the first dielectric layer, wherein the backside conductive layer is in the second dielectric layer.

Example 18 includes the electronic device of Example 17, wherein the backside conductive layer is a first backside conductive layer, and the at least one of the one or more dies further comprises one or more additional dielectric layers beneath the second dielectric layer, and a second backside conductive layer extending through one of the one or more additional dielectric layers.

Example 19 includes the electronic device of any one of Examples 12-18, wherein the first source or drain region is an n-type source or drain region and the second source or drain region is a p-type source or drain region.

Example 20 includes the electronic device of any one of Examples 12-19, wherein the backside conductive layer includes a first section that extends lengthwise along a first direction and a second section that extends lengthwise along a second direction, the second direction being substantially orthogonal to the first direction.

Example 21 includes the electronic device of Example 20, wherein the first section of the backside conductive layer contacts the first conductive contact and the second section of the backside conductive layer contacts the second conductive contact.

Example 22 includes the electronic device of any one of Examples 12-21, further comprising a printed circuit board, wherein the chip package is coupled to the printed circuit board.

Example 23 is a method of forming an integrated circuit. The method includes forming a first fin and a second fin comprising first and second semiconductor regions extending above a substrate; forming a first dielectric layer adjacent to a subfin portion of each of the first and second fins; forming sacrificial gates and spacer structures over the first fin and the second fin; removing portions of the first fin and the second fin not covered by the sacrificial gates and spacer structures; removing subfin portions of the first fin and the second fin to form subfin recesses; forming sacrificial plugs within the subfin recesses; forming a first source or drain region at exposed ends of the first semiconductor region and a second source or drain region at exposed ends of the second semiconductor region; removing the substrate to expose a backside of the sacrificial plugs; replacing the sacrificial plugs with a first conductive contact beneath the first source or drain region and a second conductive contact beneath the second source or drain region; forming a second dielectric layer beneath the first dielectric layer; and forming a conductive layer through the second dielectric layer and contacting both the first conductive contact and the second conductive contact.

Example 24 includes the method of Example 23, wherein the first and second semiconductor regions each includes an alternating stack of first semiconductor layers and second semiconductor layers. The method further includes removing the second semiconductor layers to form suspended nanoribbons from the first semiconductor layers.

Example 25 includes the method of Example 23 or 24, further comprising replacing the sacrificial gates with gate structures that extend across the first and second semiconductor regions.

Example 26 includes the method of any one of Examples 23-25, further comprising forming a third dielectric layer beneath the second dielectric layer, and forming a conductive via through both the second dielectric layer and the third dielectric layer.

Example 27 is an integrated circuit that includes a first semiconductor device having a first semiconductor region extending in a first direction from a first source or drain region, a second semiconductor device having a second semiconductor region extending in the first direction from a second source or drain region, a first dielectric layer beneath the first source or drain region and the second source or drain region, a first conductive contact extending through the first dielectric layer and contacting a lower surface of the first source or drain region, a second conductive contact extending through the first dielectric layer and contacting a lower surface of the second source or drain region, a second dielectric layer beneath the first dielectric layer, and a backside conductive layer extending through the second dielectric layer and contacting both the first conductive contact and the second conductive contact.

Example 28 includes the integrated circuit of Example 27, wherein the first semiconductor device includes a gate structure extending over the first semiconductor region along a second direction and the second semiconductor device includes the gate structure extending over the second semiconductor region along the second direction, the second direction being substantially orthogonal to the first direction.

Example 29 includes the integrated circuit of Example 27, wherein the first semiconductor device includes a first gate structure extending over the first semiconductor region along a second direction and the second semiconductor device includes a second gate structure extending over the second semiconductor region along the second direction and parallel to the first gate structure.

Example 30 includes the integrated circuit of any one of Examples 27-29, further comprising a frontside contact on a top surface of the first source or drain region or the second source or drain region.

Example 31 includes the integrated circuit of any one of Examples 27-30, wherein the first conductive contact and the second conductive contact extend through an entire thickness of the first dielectric layer.

Example 32 includes the integrated circuit of any one of Examples 27-31, wherein the backside conductive layer extends through an entire thickness of the second dielectric layer.

Example 33 includes the integrated circuit of any one of Examples 27-32, wherein the first source or drain region is an n-type source or drain region and the second source or drain region is a p-type source or drain region.

Example 34 includes the integrated circuit of any one of Examples 27-33, wherein the backside conductive layer includes a first section that extends lengthwise along the first direction and a second section that extends lengthwise along a second direction, the second direction being substantially orthogonal to the first direction.

Example 35 includes the integrated circuit of Example 34, wherein the first section of the backside conductive layer contacts the first conductive contact and the second section of the backside conductive layer contacts the second conductive contact.

Example 36 includes the integrated circuit of any one of Examples 27-35, wherein the backside conductive layer is a first backside conductive layer and the integrated circuit further includes one or more additional dielectric layers beneath the second dielectric layer, and a second backside conductive layer extending through one of the one or more additional dielectric layers.

Example 37 is a printed circuit board that includes the integrated circuit of any one of Examples 27-36.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending in a first direction from a first source or drain region;
a second semiconductor device having a second semiconductor region extending in the first direction from a second source or drain region;
a first conductive contact on an underside of the first source or drain region and a second conductive contact on an underside of the second source or drain region; and
a backside conductive layer coupled between the first conductive contact and the second conductive contact.

2. The integrated circuit of claim 1, wherein the first semiconductor device includes a gate structure extending over the first semiconductor region along a second direction and the second semiconductor device includes the gate structure extending over the second semiconductor region along the second direction, the second direction being substantially orthogonal to the first direction.

3. The integrated circuit of claim 1, wherein the first semiconductor device includes a first gate structure extending over the first semiconductor region along a second direction and the second semiconductor device includes a second gate structure extending over the second semiconductor region along the second direction and parallel to the first gate structure, the second direction being substantially orthogonal to the first direction.

4. The integrated circuit of any one of claims 1 through 3, further comprising a frontside contact on a top surface of the first source or drain region or the second source or drain region.

5. The integrated circuit of any one of claims 1 through 4, further comprising a dielectric layer beneath the first source or drain region and the second source or drain region, such that the first conductive contact and the second conductive contact extend through an entire thickness of the dielectric layer.

6. The integrated circuit of claim 5, wherein the dielectric layer is a first dielectric layer and the integrated circuit further comprises a second dielectric layer beneath the first dielectric layer, wherein the backside conductive layer extends through the second dielectric layer.

7. The integrated circuit of claim 6, wherein the backside conductive layer is a first backside conductive layer, the integrated circuit further comprising:
one or more additional dielectric layers beneath the second dielectric layer; and
a second backside conductive layer extending through one of the one or more additional dielectric layers.

8. The integrated circuit of any one of claims 1 through 7, wherein the first source or drain region is an n-type source or drain region and the second source or drain region is a p-type source or drain region.

9. The integrated circuit of any one of claims 1 through 8, wherein the backside conductive layer includes a first section that extends lengthwise along the first direction and a second section that extends lengthwise along a second direction, the second direction being substantially orthogonal to the first direction.

10. The integrated circuit of claim 9, wherein the first section of the backside conductive layer contacts the first conductive contact and the second section of the backside conductive layer contacts the second conductive contact.

11. A printed circuit board that includes the integrated circuit of any one of claims 1 through 10.

12. A method of forming an integrated circuit, the method comprising:
forming a first fin and a second fin comprising first and second semiconductor regions extending above a substrate;
forming a first dielectric layer adjacent to a subfin portion of each of the first and second fins;
forming sacrificial gates and spacer structures over the first fin and the second fin;
removing portions of the first fin and the second fin not covered by the sacrificial gates and spacer structures;
removing subfin portions of the first fin and the second fin to form subfin recesses; forming sacrificial plugs within the subfin recesses;
forming a first source or drain region at exposed ends of the first semiconductor region and a second source or drain region at exposed ends of the second semiconductor region;
removing the substrate to expose a backside of the sacrificial plugs;
replacing the sacrificial plugs with a first conductive contact beneath the first source or drain region and a second conductive contact beneath the second source or drain region;
forming a second dielectric layer beneath the first dielectric layer; and
forming a conductive layer through the second dielectric layer and contacting both the first conductive contact and the second conductive contact.

13. The method of claim 12, wherein the first and second semiconductor regions each includes an alternating stack of first semiconductor layers and second semiconductor layers, and the method further includes removing the second semiconductor layers to form suspended nanoribbons from the first semiconductor layers.

14. The method of claim 12 or 13, further comprising replacing the sacrificial gates with gate structures that extend across the first and second semiconductor regions.

15. The method of any one of claims 12 through 14, further comprising:
forming a third dielectric layer beneath the second dielectric layer; and
forming a conductive via through both the second dielectric layer and the third dielectric layer.
